# EUROPEAN PATENT APPLICATION

(11) **EP 1 237 399 A1**
(43) Date of publication of application: **04.09.2002**
(21) Application number: 00979096.5
(22) Date of filing: 05.12.2000
(51) Int. Cl.: H05K 3/46

(54) **MULTILAYERED PRINTED CIRCUIT BOARD**

(30) Priority: 06.12.1999 JP 34583699
(71) Applicant: IDEMITSU PETROCHEMICAL CO., LTD., Tokyo 130-0015 (JP)
(72) Inventor: OTSUKI, Yusuke, Ichihara-shi, Chiba 299-0107 (JP); YAMATO, Hiroyasu, Sumida-ku, Tokyo 130-0015 (JP); ISOGAI, Osamu, Sumida-ku, Tokyo 130-0015 (JP)
(74) Representative: Gille Hrabal Struck Neidlein Prop Roos
(86) International application number: JP0008601
(87) International publication number: WO01043515

(57) **Abstract**

A multilayer printed wiring board which comprises B layer laminated on one or both faces of A layer, wherein A layer is a layer constituted with one or more layers which comprise a resin composition comprising at least one resin selected from epoxy resins, phenolic resins, unsaturated polyester resins and polyimide resins of a bismaleimide type and B layer is a layer constituted with one or more layers which comprise a resin composition comprising 40% by weight or more of a styrenic resin having a syndiotactic configuration.

The printed wiring board exhibits excellent properties at high frequencies and has excellent mechanical strength and impact strength.

## Description

### TECHNICAL FIELD

The present invention relates to a multilayer printed wiring board used in the electric and electronic fields and, more particularly, to a multilayer printed wiring board exhibiting excellent properties at high frequencies and having excellent mechanical strength.

### BACKGROUND ART

Electronic instruments such as portable telephones, various types of audio-visual instruments and personal computers have been developed and are used in the ordinary living, penetrating deeply into the life style. Printed wiring boards are widely used in these electronic instruments as the fundamental members. For these printed wiring boards, it is required that speed of transfer of electronic signals be fast so that speed of operation in electronic circuits increases and loss of electronic signals in transfer be small so that formed energy loss decreases. These properties are deeply related to electric properties of resins forming major portions of the printed wiring boards. More particularly, magnitudes of permittivity and dielectric loss of the resins greatly affect the speed of transfer and the loss of electric signals in transfer and it is desired that values of these properties in high frequency regions are held as small as possible. Resistance to soldering and heat resistance which are required in the preparation of electronic members and mechanical properties such as strength which are required for molded articles are also important factors required for the resins.

Heretofore, fluororesins, epoxy resins, polyolefins resins such as polyethylene and the like, polyarylene sulfide resins and the like resins have been used as the above resins. However, these resins have drawbacks in that fluororesins have a poor property for injection molding and are expensive, epoxy resins have insufficient electric properties and polyolefins resins have poor heat resistance.

Moreover, it is required that printed wiring boards exhibit still higher performances. To decrease the size of a substrate and increase the density in a substrate, it has been attempted that the sheet of a molded resin forming the main portion of a printed wiring board is made of a multilayer laminate rather than a single layer sheet.

On the other hand, as the information communication network is highly developed, media of the wireless mobile communication have shifted to waves in high frequency regions such as quasi-microwave or waves of higher frequencies and terminal instruments transferring and receiving information are becoming extremely small and light. However, it is the actual present situation that a printed wring board exhibiting excellent overall properties, i.e., excellent properties at high frequencies such as a small permittivity and excellent mechanical properties and impact strength, cannot be found.

### DISCLOSURE OF THE INVENTION

The present invention has an object to provide a printed wiring board exhibiting excellent properties at high frequencies and having excellent mechanical properties and impact resistance.

As the result of extensive studies by the present inventors, it was found that the above object can be effectively achieved with a multilayer printed wiring board having a specific construction and the present invention has been completed based on this knowledge. The present invention can be summarized as following:
(1) A multilayer printed wiring board which comprises B layer laminated on one or both faces of A layer, wherein
   A layer is a layer constituted with one or more layers which comprise a resin composition comprising at least one resin selected from epoxy resins, phenolic resins, unsaturated polyester resins and polyimide resins of a bismaleimide type, and
   B layer is a layer constituted with one or more layers which comprise a resin composition comprising 40% by weight or more of a styrenic resin having a syndiotactic configuration (hereinafter, occasionally referred to as SPS); and
(2) A multilayer printed wiring board described in (1), wherein a ratio of a total thickness of A layer to a total thickness of B layer in a sectional direction is 200:1 to 1:1.

### THE MOST PREFERRED EMBODIMENT TO CARRY OUT THE INVENTION

The most preferred embodiments to carry out the present invention will be described in the following.

The multilayer printed wiring board of the present invention comprises B layer laminated on one or both faces of A layer, wherein A layer is a layer constituted with one or more layers which comprise at least one resin composition selected from epoxy resin compositions, phenolic resin compositions, unsaturated polyester resin compositions and polyimide resin compositions of the bismaleimide type.

The resin used in A layer in the present invention is as described above. The resin composition will be described more specifically in the following.

### [A-1] Epoxy resin composition

The epoxy resin composition used in the present invention means, in general, a material (a cured epoxy resin) obtained by curing a composition which is composed of epoxy oligomers, curing agents and, where necessary, reinforcing materials as the basic components and optionally contains various additives such as flame retardants and plasticizers as the typical examples.

The cured epoxy resin includes cured resins of the glycidyl ether type, cured resins of the glycidyl ester type and cured resins of the glycidylamine type, which are different with respect to the type of the raw material used in the preparation (the epoxy oligomer). Examples of the epoxy oligomer used as the raw material for the cured resin of the glycidyl ether type include bisphenol A diglycidyl ether, bisphenol F diglycidyl ether, brominated bisphenol A diglycidyl ether, hydrogenated bisphenol A diglycidyl ether, phenol novolak glycidyl ether (for example, EPIKOTE 154, manufactured by YUKA SHELL EPOXY Co., Ltd.), o-cresol novolak glycidyl ether (for example, EPIKOTE 180S65, manufactured by YUKA SHELL EPOXY Co., Ltd.) and the like. Examples of the epoxy oligomer used as the raw material for the cured resin of the glycidyl ester type include glycidyl hexahydrophthalate and the like. Examples of the epoxy oligomer used as the raw material for the cured resin of the glycidylamine type include tetraglycidyldiaminodiphenylmethane, triglycidyl-isocyanurate, 1,3-bis(N,N-diglycidylaminomethyl)cyclohexane and the like. Among these epoxy oligomers, epoxy oligomers of the bisphenol A type such as bisphenol A diglycidyl ether, brominated bisphenol A diglycidyl ether and the like, epoxy oligomers of the novolak type such as phenol novolak glycidyl ether, o-cresol novolak glycidyl ether, DPP novolak glycidyl ether and the like; epoxy oligomers obtained by modifying these epoxy oligomers; and combinations of these epoxy oligomers; are preferable. The epoxy oligomer may be used singly or in combination of two or more.

Examples of the curing agent include diethylenetriamine, triethylenetetramine, isophoronediamine, diaminodiphenylmethane, diamindiphenylsulfone, dicyandiamide, hexahydrophthalic anhydride, methyltetrahydrophthalic anhydride, methylnadic anhydride and the like. Among these curing agents, diamine curing agents such as isophoronediamine as the typical example are preferably used. The curing agent may be used singly or in combination of two or more.

Examples of the reinforcing material include glass fibers, glass cloths, paper and the like. Among these reinforcing materials, glass cloths are preferably used. The reinforcing material may be used singly or in combination of two or more.

The layer comprising the cured epoxy resin which is obtained from these components may be used singly or in combination of two or more.

### [A-2] Phenolic resin composition

The phenolic resin composition used in the present invention means, in general, a material (a cured phenolic resin) obtained by curing a composition which is composed of phenolic monomers, aldehydes and, where necessary, reinforcing materials as the basic components and optionally contains various additives such as flame retardants and plasticizers as the typical examples.

Examples of the phenolic monomer include phenol, cresol, xylenol, p-tert-butylphenol, p-phenylphenol, resorcinol, compounds obtained by modifying these compounds and the like. The phenolic monomer may be used singly or in combination of two or more.

As the aldehyde, formaldehyde is mainly used.

Examples of the reinforcing material include glass fibers, glass cloths, paper and the like. Among these reinforcing materials, glass cloths are preferably used. The reinforcing material may be used singly or in combination of two or more.

The layer comprising the cured phenolic resin which is obtained from these components may be used singly or in combination of two or more.

### [A-3] Unsaturated polyester resin composition

The unsaturated polyester resin composition used in the present invention means, in general, a material obtained by curing a composition which is composed of unsaturated polyester prepolymers having an ester bond (-COO-) and an unsaturated bond (-C=C-) in the main chain and, where necessary, reinforcing materials as the basic components and optionally contains various additives such as flame retardants and plasticizers as the typical examples.

The unsaturated polyester prepolymer having an ester bond and an unsaturated bond in the main chain can be obtained by polymerization reaction of dibasic acids including unsaturated dibasic acids and polyhydric alcohols. Examples of the unsaturated dibasic acid include maleic anhydride, fumaric acid, itaconic acid, compounds obtained by modifying these compounds and the like. The unsaturated dibasic acid may be used singly or in combination of two or more. Examples of the dibasic acid include phthalic anhydride, isophthalic acid, terephthalic acid, succinic acid, adipic acid, azelaic acid, sebacic acid, tetrahydrophthalic anhydride, hexahydrophthalic anhydride, tetrabromophthalic anhydride, tetrachlorophthalic anhydride, HET acid anhydride, endomethylene-tetrahydrophthalic anhydride, compounds obtained by modifying these compounds and the like. The dibasic acid may be used singly or in combination of two or more.

Examples of the polyhydric alcohol include ethylene glycol, propylene glycol, 1,3-butylene glycol, 1,6-hexanediol, diethylene glycol, dipropylene glycol, neopentyl glycol, triethylene glycol, hydrogenated bisphenol A, bisphenol dihydroxypropyl ether, compounds obtained by modifying these compounds and the like. The polyhydric alcohol may be used singly or in combination of two or more.

Examples of the reinforcing material include glass fibers, glass cloths, paper and the like. Among these reinforcing materials, glass cloths are preferably used. The reinforcing material may be used singly or in combination of two or more.

The layer comprising the cured unsaturated polyester resin which is obtained from these components may be used singly or in combination of two or more.

### [A-4] Polyimide resin composition of the bismaleimide type

"The polyimide resin composition of the bismaleimide type" used in the present invention means, in general, a material obtained by curing a composition which is composed of bismaleimide monomers synthesized from aromatic diamines and maleic anhydride and, where necessary, reinforcing materials as the basic components and optionally contains various additives such as flame retardants and plasticizers as the typical examples. Examples of the reinforcing material include glass fibers, glass cloths, paper and the like. Among these reinforcing materials, glass cloths are preferably used. The reinforcing material may be used singly or in combination of two or more.

Examples of the polyimide resin composition of the bismaleimide type include commercial products such as BT RESIN manufactured by MITSUI GAS KAGAKU Co., Ltd. and XU 292 manufactured by CIBA GEIGY Company.

The layer comprising the polyimide resin composition of the bismaleimide type which is obtained from these components may be used singly or in combination of two or more.

The multilayer printed wiring board of the present invention comprises A layer described above and B layer constituted with one or more layers which comprise a resin composition comprising 40% by weight or more of SPS.

When the content of SPS in B layer is less than 40% by weight, there is the possibility that heat resistance and the properties at high frequencies are lost and such a content is not preferable. The content of SPS is preferably 45% by weight or more and more preferably 50% by weight or more.

The composition comprising 40% by weight or more of SPS may occasionally comprise, in addition to SPS, thermoplastic resins other than SPS, rubbery elastomers, inorganic fillers and additives such as antioxidants, nucleating agents, plasticizers, mold releases, flame retardants, auxiliary flame retardants, pigments, antistatic agents and the like.

The components constituting the composition comprising 40% by weight or more of SPS will be described more specifically in the following.

### [B-1] SPS

The syndiotactic configuration of SPS used in the present invention means that the stereochemical structure has a highly syndiotactic configuration. In other words, phenyl groups of the side groups are alternately placed at the opposite positions with respect to the main chain formed with the carbon-carbon bonds. The tacticity in the stereochemical structure is quantitated by the measurement of the nuclear magnetic resonance using an isotope of carbon (¹³C-NMR). The tacticity measured in accordance with the ¹³C-NMR method can show the content of a sequence in which a specific number of the constituting units are bonded in sequence, such as a diad in which two constituting units are bonded in sequence, a triad in which three constituting units are bonded in sequence, and a pentad in which five constituting units are bonded in sequence. In the present invention, SPS means polystyrene, a poly(alkylstyrene), a poly(halogenated styrene), a poly(halogenated alkylstyrene), a poly(alkoxystyrene), a poly(vinylbenzoic acid ester), a hydrogenation product of these polymers, a mixture of these polymers, or a copolymer containing constituting units of these polymers as the main components, which generally has a syndiotacticity of 75 % or more, preferably 85 % or more, expressed in terms of the content of the racemic diad, or 30 % or more, preferably 50 % or more, expressed in terms of the content of the racemic pentad. Examples of the poly(alkylstyrene) include poly(methylstyrene), poly(ethylstyrene), poly(isopropylstyrene), poly-(tertiary-butylstyrene), poly(phenylstyrene), poly(vinylnaphthalene), poly(vinylstyrene) and the like. Examples of the poly(halogenated styrene) include poly(chlorostyrene), poly(bromostyrene), poly-(fluorostyrene) and the like. Examples of the poly(halogenated alkylstyrene) include poly(chloromethylstyrene) and the like. Examples of the poly(alkoxystyrene) include poly(methoxystyrene), poly-(ethoxystyrene) and the like.

Particularly preferable examples of the styrenic polymers described above include polystyrene, poly(p-methylstyrene), poly(m-methylstyrene), poly(p-tertiary-butylstyrene), poly(p-chlorostyrene), poly(m-chlorostyrene), poly(p-fluorostyrene), hydrogenated polystyrene, copolymers comprising constituting units of these compounds and the like.

It is preferable that the molecular weight of SPS used in B layer of the printed wiring board of the present invention is 100,000 to 1,000,000.

SPS described above can be produced, for example, by polymerizing styrenic monomers (monomers corresponding to the styrenic polymers described above) in a solvent of an inert hydrocarbon solvent or in the absence of solvents using a condensation product of a titanium compound, water and trialkylaluminum as the catalyst (Japanese Patent Application Laid-Open No. Showa 62(1987)-187708). The poly(halogenated alkylstyrene) can be obtained in accordance with the process disclosed in Japanese Patent Application Laid-Open No. Heisei 1(1989)-46912. The hydrogenation products of these polymers can be obtained in accordance with the process disclosed in Japanese Patent Application Laid-Open No. Heisei 1(1989)-178505.

SPS may be used singly or in combination of two or more.

### [B-2] Thermoplastic resin other than SPS

As the thermoplastic other than SPS, a desired thermoplastic can be selected from conventional thermoplastics, examples of which include polyolefinic resins such as linear high density polyethylene, linear low density polyethylene, high pressure low density polyethylene, isotactic polypropylene, syndiotactic polypropylene, block polypropylene, random polypropylene, polybutene, 1,2-polybutadiene, poly-4-methylpentene, cyclic polyolefins and the like; polystyrenic resins such as atactic polystyrene, isotactic polystyrene, high impact polystyrene (HIPS), ABS resins, AS resins and the like; polyester resins such as polycarbonates, polyethylene terephthalate, polybutylene phthalate and the like; polyamide resins such as polyamide 6, polyamide 6,6 and the like; polyphenylene ethers; PPS, resins obtained by modifying these resins and the like. Among these thermoplastic resins, polypropylene, polystyrenic resins such as atactic polystyrene, isotactic polystyrene, high impact polystyrene (HIPS), ABS resins, AS resins and the like, polyphenylene ethers, polyphenylene ethers modified with fumaric acid and polyphenylene ethers modified with maleic acid are preferably used. The thermoplastic resin may be used singly or in combination of two or more.

### [B-3] Rubbery elastomer

Examples of the rubbery elastomer used in the present invention include natural rubber; polybutadiene; polyisoprene; polyisobutylene, neoprene; polysulfide rubber; thiokol rubber; acrylic rubber; urethane rubber; silicone rubber; epichlorohydrine rubber; styrene-butadiene block copolymers (SBR); hydrogenated styrene-butadiene block copolymers (SEB); styrene-butadiene-styrene block copolymers (SBS); hydrogenated styrene-butadiene-styrene block copolymers (SEBS); styrene-isoprene block copolymers (SIR); hydrogenated styrene-isoprene block copolymers (SEP); styrene-isoprene-styrene block copolymers (SIS); hydrogenated styrene-isoprene-styrene block copolymers (SEPS); olefinic rubbers such as ethylene-propylene rubber (EPM), ethylene-propylene-diene rubber (EPDM), ethylene-octene copolymer elastomer and the like; particulate elastomers of the core-shell type such as butadiene-acrylonitrile-styrene core-shell rubbers (ABS), methyl methacrylate-butadiene-styrene core-shell rubbers (MBS), methyl methacrylate-butyl acrylate-styrene core-shell rubbers (MAS), octyl acrylate-butadiene-styrene core-shell rubbers (MABS), alkyl acrylate-butadiene-acrylonitrile-styrene core-shell rubbers (AABS), butadiene-styrene core-shell rubbers (SBR), core-shell rubbers containing siloxanes such as methyl methacrylate-butyl acrylate-siloxane core-shell rubbers and the like; and rubbers obtained by modifying these rubbers. Among these rubbery elastomers, SBR, SEB, SBS, SEBS, SIR, SEP, SIS, SEPS, core-shell rubbers, EPM, EPDM, ethylene-octene copolymer elastomers and rubbers obtained by modifying these rubbers are preferably used. The rubbery elastomer may be used singly or in combination of two or more.

### [B-4] Inorganic filler

The inorganic filler may have various shapes, such as fiber, granules, powder, and the like. As the filler having the shape of fiber, glass fiber, carbon fiber, whisker and the like can be used. As for the form of the filler, the filler may have a form of a cloth, a mat, a cut bundle, short fibers, filaments, or whiskers. When the filler has the form of cut bundles, it is preferable that the length is 0.05 to 50 mm and the diameter of a fiber is 5 to 20 µm. Examples of the filler having a shape of granules or powder include talc, carbon black, graphite, titanium dioxide, silica, mica, calcium sulfate, calcium carbonate, barium carbonate, magnesium carbonate, magnesium sulfate, barium sulfate, oxysulfate, tin oxides, alumina, kaolin, silicon carbide, metal powders, glass powder, glass flakes, glass beads and the like.

Among the various types of fillers described above, carbon fiber; calcium carbonate; and glass fillers such as glass powder, glass flakes, glass beads, glass filament, glass fiber, glass roving and glass mat are preferable. Among these fillers, glass fillers are more preferable and glass fiber is most preferable.

As the filler described above, fillers treated on the surface are preferable. Coupling agents for the surface treatment are used for improving adhesion of the filler to the resin. A desired coupling agent can be selected from conventional coupling agents such as silane coupling agents, titanium coupling agents and the like. Among the conventional coupling agents, aminosilanes such as γ-aminopropyltrimethoxysilane, N-β-(aminoethyl)-γ-aminopropyltrimethoxysilane, γ-glycidoxypropyl-trimethoxysilane, β-(3,4-epoxycyclohexyl)ethyltrimethoxysilane and the like; epoxysilanes; and isopropyltri(N-amidoethyl, aminoethyl) titanate are preferable.

Film-forming substances for glasses may be used in combination with the above coupling agents. The film-forming substance is not particularly limited. Examples of the film-forming substance include polymers such as polyesters, polyethers, urethane polymers, epoxy polymers, acrylic polymers and vinyl acetate polymers.

The inorganic filler may be used singly or in combination of two or more.

### [B-5] Antioxidant

As the antioxidant used in the present invention, a desired antioxidant may be selected from conventional antioxidants such as antioxidants containing phosphorus, phenolic antioxidants and antioxidants containing sulfur. The antioxidants may be used singly or in combination of two or more.

### [B-6] Nucleating agent

As the nucleating agent used in the present invention, a desired nucleating agent may be selected from conventional nucleating agents such as metal salts of carboxylic acids such as aluminum di(p-t-butyl benzoate) and the like, metal salts of phosphoric acid such as sodium methylenebis(2,4-di-t-butylphenol) acid phosphate and the like, talc, phthalocyanine derivatives and the like. Examples of the commercially available nucleating agent include NA11 and NA21 manufactured by ASAHI DENKA Co., Ltd. and PTBBA-AL manufactured by DAINIPPON INK KAGAKU Co., Ltd. The nucleating agent may be used singly or in combination of two or more.

### [B-7] plasticizer

As the plasticizer used in the present invention, a desired plasticizer may be selected from conventional plasticizers such as polyethylene glycol, polyamide oligomers, ethylenebisstearoamide, phthalic esters, polystyrene oligomers, liquid paraffin, polyethylene wax, silicone oils and the like. The plasticizer may be used singly or in combination of two or more.

### [B-8] Mold release

As the mold release used in the present invention, a desired mold release may be selected from conventional mold releases such as polyethylene wax, silicone oils, long chain carboxylic acids, metal salts of long chain carboxylic acids and the like. The mold release may be used singly or in combination of two or more.

### [B-9] Flame retardant and auxiliary flame retardant

As the flame retardant used in the present invention, a desired flame retardant can be selected from conventional flame retardants, examples of which include brominated polymers such as brominated polystyrene, brominated syndiotactic polystyrene, brominated polyphenylene ether and the like and brominated aromatic compounds such as diphenylalkanes containing bromine, diphenyl ether containing bromine and the like. As the auxiliary flame retardant, a desired auxiliary flame retardant may be selected from conventional auxiliary flame retardants, examples of which include antimony compounds such as antimony trioxide and the like. The flame retardant and the auxiliary flame retardant may be used singly or in combination of two or more.

To obtain the composition of the present invention which comprises 40% by weight or more of SPS, the above components may be blended in accordance with various processes such as mixing at the ordinary temperature, mixing with melting and the like. The process for blending is not particularly limited. Among these processes for blending, mixing with melting using a twin screw extruder is preferably used. In the mixing with melting using a twin screw extruder, mixing at 270 to 350°C is preferable. When the temperature of mixing is lower than 270°C, there is the possibility that productivity decreases due to a high viscosity of the resin and such a temperature is not preferable. When the temperature of mixing exceeds 350°C, there is the possibility that thermal decomposition of the resin takes place and such a temperature is not preferable.

The multilayer printed wiring board of the present invention may have a structure in which B layer comprising one or more layers is laminated to one face of A layer which is formed into a sheet in advance or a structure in which B layer comprising one or more layers is laminated to both faces of A layer which is formed into a sheet in advance, i.e., a structure of (B layer)-(A layer)-(B layer). The structure of (B layer)-(A layer)-(B layer) is superior to the structure of (A layer)-(B layer) since the properties at high frequencies are improved.

The process for preparing the multilayer printed wiring board is not particularly limited. Examples of the process include a process in which A layer comprising an epoxy resin composition or the like is prepared by curing by pressing under heating and an SPS layer (in the form of a sheet) prepared in advance in accordance with the injection process, the extrusion process or the paper making process is pressed to the prepared A layer and heat sealed; a process in which A layer prepared in advance is inserted into a mold and B layer is formed by direct injection molding; a process in which A layer and B layer are laminated together via a thermosetting adhesive or an epoxy adhesive having heat resistance; and the like processes.

It is preferable that, in the multilayer printed wiring board of the present invention, the ratio of the total thickness of A layer to the total thickness of B layer in the sectional direction is 200:1 to 1:1 and more preferably 100:1 to 2:1. When the thickness of B layer is so small that the ratio of the total thickness of A layer to the total thickness of B layer in the sectional direction exceeds 200:1, the properties at high frequencies deteriorate. When the thickness of A layer is so small that the ratio of the total thickness of A layer to the total thickness of B layer in the sectional direction is smaller than 1:1, the mechanical properties are inferior and handling becomes difficult. Thus, the ratios outside the above range are not preferable.

With respect to the thickness of each layer, it is preferable that A layer has a thickness of 0.5 to 2 mm and B layer has a thickness smaller than 0.5 mm, more preferably a thickness smaller than 100 µm and most preferably a thickness of 10 to 70 µm.

The present invention will be described more specifically with reference to examples in the following.

The methods of evaluation and the raw materials used in Examples and Comparative Examples are as follows.

### [Methods of evaluation]

### (1) Method of measurement of bending strength

The bending strength was measured in accordance with the method of ASTM D790.

### (2) Method of measurement of permittivity at 4 GHz

The permittivity at 4 GHz was measured in accordance with the method of ASTM D150.

### (3) Method of testing heat resistance using the reflow model

A substrate for printing was placed in an oven at 250°C for 20 seconds. The appearance of the substrate was visually observed and the heat resistance was evaluated.

### [Raw materials]

### (1) Syndiotactic polystyrene (i)

Mw=230,000, Mw/Mn=2.20 (measured in accordance with the gel permeation chromatography in 1,2,4-trichlorobenzene as the solvent at 150°C; values obtained as those of the corresponding polystyrene).

### (2) Polystyrene (GPPS)

HH30, manufactured by IDEMITSU PETROCHEMICAL Co., Ltd.

### (3) Rubbery elastomer (i)

An elastomer of the SEBS type, Kraton G1651, manufactured by SHELL Company.

### (4) Rubbery elastomer (ii)

An elastomer of the SEPS type, SEPTON 2104, manufactured by KURARAY Co., Ltd.

### (5) Rubbery elastomer (iii)

An ethylene-octene copolymer elastomer, ENGAGE 8150, manufactured by DUPONT-DOW ELASTOMER Company.

### (6) Thermoplastic resin other than SPS (i)

Polyphenylene ether modified with fumaric acid (FAPPO) which was prepared in accordance with a process similar to that used in Preparation Example 1.

### (7) Antioxidant (i)

IRGANOX 1010, manufactured by CIBA-GEIGY Company.

### (8) Antioxidant (ii)

PEP 36, manufactured by ASAHI DENKA Co., Ltd.

### (9) Flame retardant (i)

1,2-Di(pentabromophenyl)ethane, SAYTEX 8010, manufactured by ETHYL Corporation.

### (10) Auxiliary flame retardant (i)

Antimony trioxide, PATOX-M, manufactured by NIPPON SEIKO Co., Ltd.

### (11) Halogen scavenger (i)

DHT-4A, manufactured by KYOWA KAGAKU Co., Ltd.

### Preparation Example 1 (Preparation of polyphenylene ether modified with fumaric acid)

Polyphenylene ether (inherent viscosity: 0.45 dl/g, measured in chloroform at 25°C) in an amount of 1 kg, 30 g of fumaric acid and 20 g of 2,3-dimethyl-2,3-diphenylbutane (NOFMER BC, manufactured by NIPPON YUSHI Co., Ltd.) as the radical generator were dry blended. The obtained mixture was mixed with melting by a 30 mm twin-screw extruder at a rotation speed of a screw of 200 rpm at a set temperature of 300°C. The temperature of the resin was about 331°C at this time. The obtained strands were cooled and pelletized and polyphenylene ether modified with fumaric acid was obtained. To obtain the fraction of modification, 1 g of the obtained polyphenylene ether modified with fumaric acid was dissolved in ethylbenzene and reprecipitated with methanol. The recovered polymer was extracted with methanol using a Soxhlet extractor and dried. The fraction of modification was obtained from the intensity of the carbonyl absorption in the infrared absorption spectrum of the polymer and from the titration of the polymer. The fraction of modification was found to be 1.45% by weight.

### Preparation Example 2

Syndiotactic polystyrene (i) in an amount of 90 parts by weight, 2 parts by weight of rubbery elastomer (i), 2 parts by weight of rubbery elastomer (ii), 6 parts by weight of rubbery elastomer (iii), 2 parts by weight of thermoplastic resin other than SPS (i), 23 parts by weight of flame retardant (i), 4 parts by weight of auxiliary flame retardant (i), 1 part by weight of halogen scavenger (i), 0.1 part by weight of antioxidant (i) and 0.1 part by weight of antioxidant (ii) were dry blended. The obtained mixture was mixed with melting by a twin-screw extruder at a cylinder temperature of 290°C. The obtained strands were cooled by passing through a water tank and pelletized (the content of SPS: 69% by weight).

The obtained pellets were molded in accordance with the flat film die casting using a 30 mm single screw extruder at a cylinder temperature of 290°C, a die temperature of 300°C and a roll temperature of 80°C and a film having a thickness of 100 µm was obtained.

### Preparation Example 3

Syndiotactic polystyrene (i) in an amount of 45 parts by weight, 55 parts by weight of polystyrene (GPPS), 2 parts by weight of rubbery elastomer (i), 2 parts by weight of rubbery elastomer (ii), 6 parts by weight of rubbery elastomer (iii), 2 parts by weight of thermoplastic resin other than SPS (i), 23 parts by weight of flame retardant (i), 4 parts by weight of auxiliary flame retardant (i), 1 part by weight of halogen scavenger (i), 0.1 part by weight of antioxidant (i) and 0.1 part by weight of antioxidant (ii) were dry blended. The obtained mixture was mixed with melting by a twin-screw extruder at a cylinder temperature of 290°C. The obtained strands were cooled by passing through a water tank and pelletized (the content of SPS: 32% by weight).

The obtained pellets were molded in accordance with the flat film die casting using a 30 mm single screw extruder at a cylinder temperature of 290°C, a die temperature of 300°C and a roll temperature of 80°C and a film having a thickness of 100 µm was obtained.

### Example 1

A commercially available glass cloth-epoxy substrate FR-4 (the thickness: 1.0 mm) was used as A layer. Two layers of the film obtained in Preparation Example 2 were laminated to one face of A layer via an epoxy adhesive to form B layer and a substrate having a thickness of 1.2 mm was obtained. A layer had a thickness of 1.0 mm and B layer had a thickness of 0.2 mm. The substrate was evaluated in accordance with the methods described above. The results are shown in Table 1.

### Example 2

The same procedures as those conducted in Example 1 were conducted except that one layer of the film obtained in Preparation Example 2 was laminated to both faces of FR-4 used as A layer to form B layers and a substrate having a thickness of 1.2 mm was obtained. A layer had a thickness of 1.0 mm and B layers each had a thickness of 0.1 mm. The results are shown in Table 1.

### Comparative Example 1

A commercially available glass cloth-epoxy substrate FR-4 (the thickness: 1.2 mm) which was used as A layer was evaluated in accordance with the methods described above. The results are shown in Table 1.

### Comparative Example 2

The film obtained in Preparation Example 2 was used as B layer and a prepreg having a thickness of 0.2 mm was prepared in accordance with the method described in Example 1 of Japanese Patent Application Laid-Open No. Heisei 9(1997)-12746. Six layers of the obtained prepreg was laminated together in accordance with the pressing process at 30°C and a substrate for printing having a thickness of 1.2 mm was obtained. The obtained substrate for printing was evaluated in accordance with the methods described above. The results are shown in Table 1.

### Comparative Example 3

The same procedures as those conducted in Example 1 was conducted except that the film obtained in Preparation Example 3 was used. The results are shown in Table 1.

**Table 1**

| | Example 1 | Example 2 | Comparative Example 1 | Comparative Example 2 | Comparative Example 3 |
|---|---|---|---|---|---|
| Bending strength (MPa) | 430 | 410 | 450 | 150 | 420 |
| | | | | | |
| Permittivity (6 GHz) | 4.0 | 3.9 | 5.5 or greater | 3.1 | 4.1 |
| | | | | | |
| Oven test | no change in appearance | no change in appearance | no change in appearance | no change in appearance | partial melting at the surface |

### INDUSTRIAL APPLICABILITY

The multilayer printed wiring board of the present invention exhibits excellent properties at high frequencies such as low permittivity and the like and has excellent mechanical strength and impact strength.

## Claims

1. A multilayer printed wiring board which comprises B layer laminated on one or both faces of A layer, wherein
A layer is a layer constituted with one or more layers which comprise a resin composition comprising at least one resin selected from epoxy resins, phenolic resins, unsaturated polyester resins and polyimide resins of a bismaleimide type, and
B layer is a layer constituted with one or more layers which comprise a resin composition comprising 40% by weight or more of a styrenic resin having a syndiotactic configuration.

2. A multilayer printed wiring board according to Claim 1, wherein a ratio of a total thickness of A layer to a total thickness of B layer in a sectional direction is 200:1 to 1:1.
